# EUROPÄISCHE PATENTSCHRIFT

(11) **EP 1 166 135 B1**
(45) Veröffentlichungstag und Bekanntmachung des Hinweises auf die Patenterteilung: **12.02.2003**
(21) Anmeldenummer: 00920341.5
(22) Anmeldetag: 25.02.2000
(51) Int. Cl.: G01R 27/14, G01L 1/20

(54) **SCHALTUNGSANORDNUNG ZUM MESSEN DER WIDERSTÄNDE EINER DRUCKSENSITIVEN WIDERSTANDSMATTE**
CIRCUIT ARRANGEMENT FOR MEASURING THE RESISTANCES OF A PRESSURE-SENSITIVE RESISTANCE MAT
CIRCUIT POUR MESURER LES RESISTANCES D'UN MAT RESISTIF SENSIBLE A LA PRESSION

(30) Priorität: 09.03.1999 DE 19910194
(43) Veröffentlichungstag der Anmeldung: 02.01.2002
(73) Patentinhaber: ROBERT BOSCH GMBH, 70442 Stuttgart (DE)
(72) Erfinder: NITSCHKE, Werner, D-71254 Ditzingen (DE); SEIBOLD, Jochen, D-72070 Tübingen (DE); MAGER, Thomas, D-72793 Pfullingen (DE); MAIER, Hermann, D-71706 Markgroeningen (DE)
(86) Internationale Anmeldenummer: DE0000535
(87) Internationale Veröffentlichungsnummer: WO00054064

(56) Entgegenhaltungen:
- EP-A- 0 791 834
- D'ALESSIO T: "Measurement errors in the scanning of piezoresistive sensors arrays" SENSORS AND ACTUATORS A,CH,ELSEVIER SEQUOIA S.A., LAUSANNE, Bd. 72, Nr. 1, 8. Januar 1999 (1999-01-08), Seiten 71-76, XP004155669 ISSN: 0924-4247

## Beschreibung

### Stand der Technik

Die vorliegende Erfindung betrifft eine Schaltungsanordnung zum Messen von matrixartig angeordneten Widerständen einer in einem Fahrzeugsitz zur Sitzbelegungserkennung angeordneten drucksensitiven Widerstandsmatte.

Eine Widerstandsmatte, mit einer Vielzahl drucksensitiver Widerstandselemente ist aus der DE 42 37 072 C1 bekannt. Eine solche Widerstandsmatte ist im Fahrzeugsitz, vorzugsweise im Beifahrersitz, integriert, um eine automatische Sitzbelegungserkennung durchführen zu können. Ob nämlich im Falle eines Crashes der zum Beifahrersitz gehörende Airbag ausgelöst werden soll oder welche Aufblasstärke günstig ist, hängt auch wesentlich davon ab, wie der Beifahrersitz belegt ist. Wird gar keine Belegung oder ein Kindersitz auf dem Fahrzeugsitz mittels der Widerstandsmatte sensiert, so soll eine Airbagauslösung vollständig unterdrückt werden. Das gleiche gilt, wenn der Beifahrersitz nicht mit einer Person sondern mit einem Gegenstand (z.B. Gepäckstück) belegt ist. Die Aufblasstärke richtet sich vorzugsweise nach der Größe der den Fahrzeugsitz belegenden Person, die sich in seinem Gewicht ausdrückt, das mit Hilfe der Widerstandsmatte gemessen werden kann. Ebenso kann mit der Widerstandsmatte eine Information über die Sitzposition der Person gewonnen werden, welche einen Einfluß auf die Aufblasstärke des Airbags haben soll. Je genauer die matrixartig angeordneten, drucksensitiven Widerstände der Widerstandsmatte gemessen werden können, desto genauer ist auch die Information über die Belegungsart bzw. Sitzposition einer Person auf dem Fahrzeugsitz.

Der Erfindung liegt daher die Aufgabe zugrunde, eine Schaltungsanordnung der eingangs genannten Art anzugeben, die mit möglichst geringem Schaltungsaufwand eine sehr genaue Widerstandsmessung der einzelnen matrixartig angeordneten Widerstände einer drucksensitiven Widerstandsmatte durchführt.

In dem Artikel von T. DÁLLESIO: "Measurement errors in the scanning of piezoresistive sensor arrays", SENSORS AND ACUATORS A, CH, ELSEVIER, Lausanne Bd. 72, Nr. 1, 08.01.1999, Seiten 71 bis 76 werden verschiedene Schaltungen zur Ansteuerung von piezoresistiven Sensoren in einer Matrix dargestellt. Dabei werden auch Puffer, wofür Operationsverstärker verwendbar sind, an den Spalten und Zeilen mit ihren Ausgängen geschaltet.

In der Offenlegungsschrift EP-791 834 A wird ein Verfahren zur Bestimmung des Widerstandswerts einer Widerstandsanordnung dargestellt, bei dem ein Leckstrom mittels Anlegen von Spannungspotentialen gleicher Größe der anschließenden Messung der sich einstellenden Spannungen und Auswertung dieses Wertes sowie der Messung des auftretenden Wertes und entsprechender Auswertung vorgenommen wird. Weiterhin wird eine Messung der zur Bestimmung des Widerstandswerts erforderlichen Größen durch Anlegen eines ersten und zweiten Spannungspotentials mit unterschiedlicher Potentialhöhe zur Erzeugung eines durch den Widerstand fließenden Prüfstroms durchgeführt, wobei diese Spannungspotentiale so gewählt sind, dass die Stromrichtung des Prüfstroms mit der Stromrichtung des Deckstroms übereinstimmt. Dann wird eine Messung der sich einstellenden Klemmspannung sowie eine Messung des Prüfstroms und eine Berechnung des Widerstandswerts mit Hilfe der gemessenen Werte für Leckstrom, Prüfstrom und Klemmspannung.

### Vorteile der Erfindung

Die genannte Aufgabe wird mit den Merkmalen des Anspruchs 1 gelöst. Danach besteht die Widerstandsmatrix aus Zeilenleitunger und Spaltenleitungen, wobei jede Zeilenleitung mit jeder Spaltenleitung über einen Widerstand verbunden ist. Jede Zeilenleitung und jede Spaltenleitung ist jeweils an den Ausgang eines Operationsverstärkers angeschlossen, so daß durch entsprechende Ansteuerung der Operationsverstärker in den Zeilen und Spalten selektiv an die einzelnen Widerstände eine Spannung angelegt werden kann. Jeder zu den Zeilen- oder Spaltenleitungen gehörende Operationsverstärker ist mit einer Stromspiegelschaltung ausgestattet, welche den durch den jeweils selektierten Widerstand fließenden Ausgangsstrom des mit diesem Widerstand verbundenen Operationsverstärkers erfaßt. Ein Prozessor ermittelt schließlich aus den durch die einzelnen Widerstände fließenden Strömen und den daran abfallenden Spannungen die Widerstandswerte. Die Stromspiegelschaltungen in den Operationsverstärkern ermöglichen eine sehr exakte Messung des durch die einzelnen Widerstände fließenden Stromes, ohne daß sehr enge Toleranzen von den Schaltungselementen gefordert werden.

Vorteilhafte Weiterbildungen der Erfindung gehen aus den Unteransprüchen hervor.

Die Stromspiegelschaltung weist vorzugsweise einen Summierer auf, der den von einer Endstufe des Operationsverstärkers zu seiner Versorgungsspannungsquelle fließenden Strom und den von der Endstufe nach Masse fließenden Strom addiert, so daß am Ausgang des Summierers der durch den jeweils selektierten Widerstand fließende Ausgangsstrom des Operationsverstärkers abgreifbar ist. Vorteilhafterweise sind in der Stromspiegelschaltung Schaltungsmittel vorgesehen, mit denen die beiden dem Summierer zugeführten Ströme in einen anderen Meßwertbereich umformbar sind. Für die Auswertung der gemessenen Ströme, die aufgrund großer Widerstandsänderungen sehr weit streuen können, ist es günstig, wenn die gemessenen Ströme in einen engeren Meßwertbereich transformiert werden.

Es ist zweckmäßig, daß die Widerstände in einer Spalte und in einer Zeile der Widerstandsmatrix feste, druckunabhängige Werte aufweisen, so daß damit Fehler auf den Zeilen- und Spaltenleitungen diagnostiziert werden können. Vorzugsweise werden diese druckunabhängigen Widerstände in einer Spalte und einer Zeile am Rand der Widerstandsmatte angeordnet, weil am Rand des Fahrzeugzitzes eher auf drucksensitive Widerstände verzichtet werden kann als in der Sitzfläche, der eigentlichen Meßfläche.

### Zeichnung

Die Erfindung wird nun anhand eines in der Zeichnung dargestellten Ausführungsbeispiels näher erläutert. Es zeigen:
Figur 1 eine Widerstandsmatrix und
Figur 2 einen Operationsverstärker, der die durch die Widerstände fließenden Ströme erfaßt.

### Beschreibung eines Ausführungsbeispiels

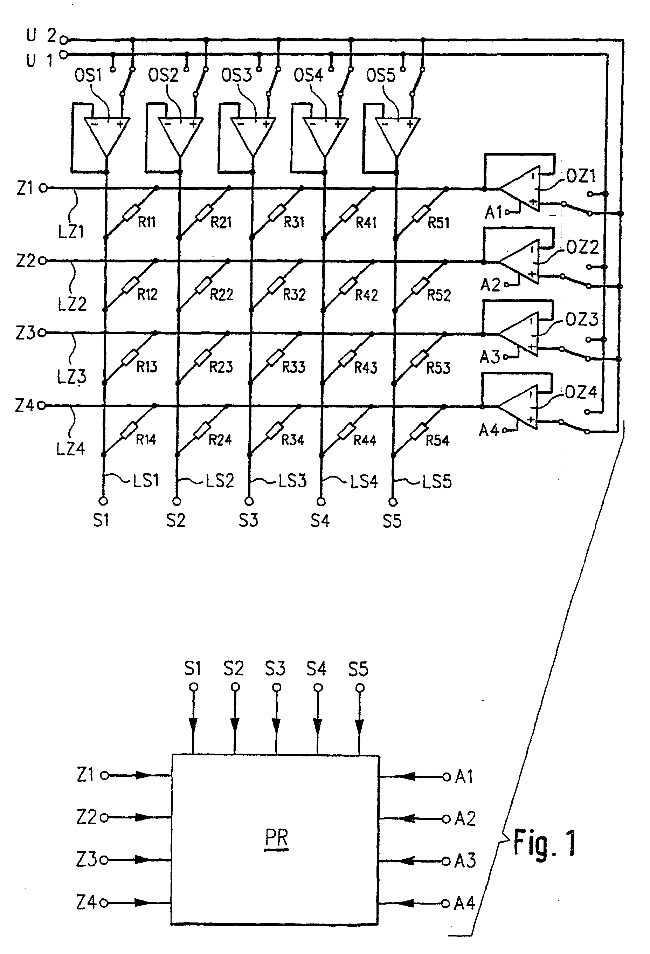

In der Figur 1 ist das Schaltbild einer Widerstandsmatrix dargestellt, wie sie bei einer drucksensitiven Widerstandsmatte, die in einem Fahrzeugsitz zur Sitzbelegungserkennung angeordnet ist, verwendet wird. Die Widerstandsmatrix besteht aus Zeilen- und Spaltenleitungen, die alle miteinander über drucksensitive Widerstände miteinander verbunden sind. In dem dargestellten Ausführungsbeispiel sind vier Zeilenleitungen LZ1, LZ2, LZ3, LZ4 und fünf Spaltenleitungen LS1, LS2, LS3, LS4, LS5 vorhanden. Es sind Widerstände Rsz vorhanden, wobei s der Spaltenindex (s = 1,2,3,4,5) und z der Zeilenindex (z = 1,2,3,4) ist. Beispielsweise verbindet der Widerstand R11 die erste Spaltenleitung LS1 mit der ersten Zeilenleitung LZ1, oder der Widerstand R32 verbindet die dritte Spaltenleitung LS3 mit der zweiten Zeilenleitung LZ2, oder der Widerstand R54 verbindet die fünfte Spaltenleitung LS5 mit der vierten Zeilenleitung LZ4 usw. So entsteht eine Matrix aus s * z Widerständen, welche über die gesamte Sitzfläche verteilt sind und auf den Druck, der in den den einzelnen Widerständen zugeordneten Zonen der Sitzfläche ausgeübt wird, mit einer Widerstandsänderung reagieren. Um die dem Druck proportionale Widerstandsänderung für alle Widerstände in der Matrix zu erfassen, wird die nachfolgend beschriebene Meßschaltung verwendet.

Jede Spaltenleitung LS1, LS2, LS3, LS4, LS5 ist jeweils an den Ausgang eines Operationsverstärkers OS1, OS2, OS3, OS4 und OS5 angeschlossen. Ebenso ist jede Zeilenleitung LZ1, LZ2, LZ3, LZ4 an den Ausgang eines Operationsverstärkers OZ1, OZ2, OZ3, OZ4 angeschlossen. Jeder dieser genannten Operationsverstärker OS1, ..., OS5 und OZ1, ..., OZ4 hat einen auf den Ausgang rückgekoppelten ersten Eingang und einen zweiten Eingang, der über einen Schalter an eine Spannung U1 oder eine Spannung U2 schaltbar ist. Die beiden Spannungen U1 und U2 sind unterschiedlich groß, z.B. beträgt die Spannung U1 = 5 V und die Spannung U2 = 2,5 V.

Ein Prozessor PR ist vorhanden, der nun die Operationsverstärker OS1, ..., OS5 für die Spalten und die Operationsverstärker OZ1, ..., OZ4 für die Zeilen der Reihe nach so an die Spannung U1 bzw. U2 schaltet, daß an alle Widerstände Rsz der Widerstandsmatrix nacheinander eine Spannung angelegt wird. Im Ausgangszustand sind sowohl die Operationsverstärker OS1, ..., OS5 für die Spaltenleitungen LS1, ..., LS5 und die Operationsverstärker OZ1, ..., OZ4 für die Zeilenleitungen LZ1, ..., LZ4 an dieselbe Spannung U2 geschaltet. Dann liegen die beiden Anschlüsse jedes Widerstandes Rsz auf dem gleichen Potential, und es fällt an ihnen keine Spannung ab, weshalb in ihnen auch kein Strom fließt. Nun wird der Operationsverstärker OS1 für die erste Spaltenleitung LS1 auf die andere Spannung U1 umgeschaltet. Alle anderen Operationsverstärker liegen weiterhin an der Spannung U2. Durch die Spannungsumschaltung des Operationsverstärkers OS1 liegen die beiden Anschlüsse der Widerstände R11, R12, R13 und R14 in der ersten Spalte an verschiedenen Potentialen, nämlich U1 und U2, so daß an ihnen eine Spannung abfällt und ebenfalls darin ein Strom fließt. Nachdem die Ströme durch diese Widerstände und auch die an ihnen abfallenden Spannungen, wie nachfolgend noch genauer beschrieben, gemessen worden sind, und daraus vom Prozessor PR die Widerstandswerte berechnet worden sind, wird der Operationsverstärker OS1 der ersten Spaltenleitung LS1 wieder auf die Spannung U2 und der Operationsverstärker OS2 der zweiten Spaltenleitung LS2 auf die Spannung U1 umgeschaltet. Dann können die Widerstandswerte der Widerstände R21, R22, R23 und R24 ermittelt werden. Auf diese Art und Weise werden die Widerstände in allen Spalten gemessen.

Um die einzelnen Widerstände der Matrix messen zu können, muß einerseits die an dem jeweiligen Widerstand anliegende Spannung und andererseits der durch den Widerstand fließende Strom gemessen werden. Die an jedem Widerstand abfallende Spannung wird von dem Prozessor PR ermittelt, an den die Ausgänge S1, S2, S3, S4 und S5 der Spaltenleitungen LS1, LS2, LS3, LS4 und LS5 und die Ausgänge Z1, Z2, Z3 und Z4 der Zeilenleitung LZ1, LZ2, LZ3 und LZ4 anliegen. Die Ströme durch die einzelnen Widerstände werden von den an die Zeilenleitungen LZ1, LZ2, LZ3 und LZ4 angeschlossenen Operationsverstärkern OZ1, OZ2, OZ3 und OZ4 erfaßt. Die Ströme durch die Widerstände könnten aber genauso über die den Spaltenleitungen LS1, LS2, LS3, LS4 und LS5 zugeordneten Operationsverstärkern OS1, OS2, OS3, OS4 und OS5 erfaßt werden. Der durch einen Widerstand fließende Strom fließt durch die an den betreffenden Widerstand angeschlossene Zeilenleitung und erscheint als Ausgangsstrom an dem an diese Zeilenleitung angeschlossenen Operationsverstärker.

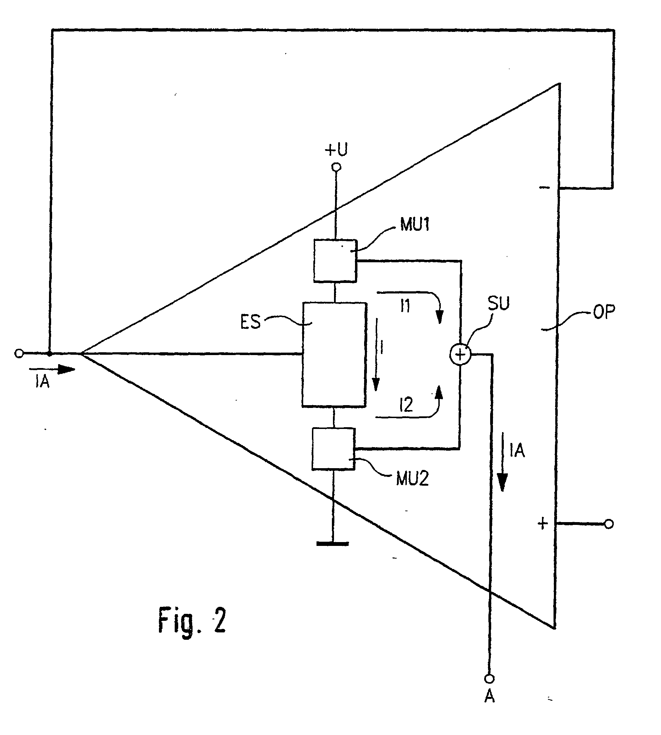

Jeder der den Zeilenleitungen zugeordneten Operationsverstärker OZ1, OZ2, OZ3 und OZ4 ist gemäß dem in der Figur 2 dargestellten Ausführungsbeispiel eines Operationsverstärkers OP mit einer Stromspiegelschaltung versehen, welche in der Lage ist, den Ausgangsstrom IA des Operationsverstärkers OP, der genau dem durch den gerade zu messenden Widerstand fließenden Strom entspricht, zu erfassen. Der Ausgangsstrom IA fließt in die Endstufe ES des Operationsverstärkers OP. Auf die Ausgestaltung der Endstufe ES wird hier nicht näher eingegangen, da sie einer bei Operationsverstärkern üblichen Schaltung entspricht, die in der Fachwelt hinreichend bekannt ist. Die Endstufe ES liegt üblicherweise einerseits an einer positiven Versorgungsspannung +U und andererseits an Masse. Die Stromspiegelschaltung besteht nun darin, daß sowohl der von der Endstufe ES zur Versorgungsspannungsquelle +U fließende Strom I1 und andererseits der von der Endstufe ES nach Masse fließende Strom I2 abgegriffen werden. Ist der in die Endstufe ES fließende Strom IA positiv, so gilt für den zur Masse fließenden Strom I2 = -(I + IA), wobei I der über die Endstufe fließende Querstrom ist. Für den zur Versorgungsspannungsquelle +U fließenden Strom I1 gilt, I1 = I. Hat nun der am Ausgang der Endstufe ES fließende Strom IA ein negatives Vorzeichen, so gilt für den Strom I1 = I + IA und für den Strom I2 = -I. Um allein den Ausgangsstrom IA, der dem durch den zu messenden Widerstand fließenden Strom entspricht, unabhängig vom Querstrom I in der Endstufe ES zu erfassen, werden die beiden Ströme I1 und I2 einem Summierer SU zugeführt. Durch die Addition der beiden Ströme I1 und I2 wird der Querstrom I der Endstufe ES eliminiert und am Ausgang A des Summierers SU erscheint nur noch der gewollte Ausgangsstrom IA.

Da die Werte der drucksensitiven Widerstände zwischen 1 kΩ und 2 MΩ schwanken, kann sich der durch die einzelnen Widerstände fließende Strom IA auch über einen sehr weiten Meßbereich von ca. 5 µA bis 5 mA ändern. Soll dieser extrem weite Strombereich auf einen geringeren Strombereich transformiert werden, weil das die Auswertung der gemessenen Ströme im Prozessor PR erleichtert, sind Schaltungsmittel MU1 und MU2 vorgesehen, mit denen die beiden dem Summierer SU zugeführten Ströme I1 und I2 in einen begrenzten definierten Strombereich um ca. 250 µA umgeformt werden. Solche Schaltungsmittel zur Meßwertumschaltung sind an sich bekannt, sie bestehen aus mehreren Dämpfungs- bzw. Verstärkerstufen.

Wie der Figur 1 zu entnehmen ist, liegen die die Ströme durch die Widerstände bereitstellenden Ausgänge A1, A2, A3 und A4 der den Zeilen zugeordneten Operationsverstärker OZ1, OZ2, OZ3 und OZ4 an dem Prozessor PR an. Anstelle von Strömen an den Ausgängen A1, A2, A3 und A4 können dem Prozessor PR auch entsprechende Meßspannungen zugeführt werden. Die Meßspannung eines jeden Operationsverstärkers kann durch einen an den Ausgang des Summierers SU angeschlossenen, vom Ausgangsstrom IA durchflossenen Widerstand gewonnen werden.

Damit Fehler der Widerstandsmatte, z.B. Brüche der Leitungen, diagnostiziert werden können, ist vorgesehen, daß die Widerstände in einer Spalte und in einer Zeile fest vorgegebene druckunabhängige Werte aufweisen. Zweckmäßigerweise befinden sich diese druckunabhängigen Widerstände in einer Spalte und einer Zeile am Rande der Widerstandsmatte. In dem dargestellten Ausführungsbeispiel wären das die Widerstände R11, R12, R13, R14, R24, R34, R44, R54. Dadurch, daß die druckunabhängigen Widerstände am Rande der Widerstandsmatte, also außerhalb der eigentlichen Sitzfläche liegen, gibt es keine Einschränkung der drucksensitiven Meßfläche.

## Patentansprüche

1. Schaltungsanordnung zum Messen von matrixartig angeordneten Widerständen einer in einem Fahrzeugsitz zur Sitzbelegungserkennung angeordneten drucksensitiven Widerstandsmatte,
- wobei die Matrix aus Zeilenleitungen (LZ1, LZ2, LZ3, LZ4) und Spaltenleitungen (LS1, LS2, LS3, LS4, LS5) besteht,
wobei jede Zeilenleitung mit jeder Spaltenleitung über einen Widerstand (R11, ..., R54) verbunden ist,
- wobei jede Zeilenleitung (LZ1, LZ2, LZ3, LZ4) und jede Spaltenleitung (LS1, LS2, LS3, LS4, LS5) an dem Ausgang je eines Operationsverstärkers (OZ1, OZ2, OZ3, OZ4; OS1, OS2, OS3, OS4, OS5) angeschlossen ist, **dadurch gekennzeichnet,**
- **daß** durch entsprechende Ansteuerung der Operationsverstärker (OZ1, OZ2, OZ3, OZ4; OS1, OS2, OS3, OS4, OS5) in den Zeilen und Spalten selektiv an die einzelnen Widerstände (R11, ..., R54) eine Spannung anlegbar ist,
- **daß** jeder zu den Zeilen- (LZ1, LZ2, LZ3, LZ4) oder Spaltenleitungen (LS1, LS2, LS3, LS4, LS5) gehörende Operationsverstärker (OZ1, OZ2, OZ3, OZ4; OS1, OS2, OS3, OS4, OS5) mit einer Stromspiegelschaltung ausgestattet ist, welche den durch den jeweils selektierten Widerstand (R11, ..., R54) fließenden Ausgangsstrom (IA) des mit diesem Widerstand verbundenen Operationsverstärkers (OZ1, OZ2, OZ3, OZ4) erfaßt
- und **daß** ein Prozessor (PR) aus den durch die einzelnen Widerstände (R11, ..., R54) fließenden Strömen (IA) und den daran abfallenden Spannungen die Widerstandswerte ermittelt.

2. Schaltungsanordnung nach Anspruch 1, **dadurch gekennzeichnet, daß** die Stromspiegelschaltung einen Summierer (SU) aufweist, der den von einer Endstufe (ES) des Operationsverstärkers (OP) zu seiner Versorgungsspannungsquelle (+U) fließenden Strom (I1) und den von der Endstufe (ES) nach Masse fließenden Strom (I2) addiert, so daß am Ausgang des Summierers (SU) der durch den jeweils selektierten Widerstand (R11, ..., R54) fließende Ausgangsstrom (IA) des Operationsverstärkers (OP) abgreifbar ist.

3. Schaltungsanordnung nach Anspruch 2, **dadurch gekennzeichnet, daß** Schaltungsmittel (MU1, MU2) in der Stromspiegelschaltung vorgesehen sind, mit denen die beiden dem Summierer (SU) zugeführten Ströme (I1, I2) in einen anderen Meßwertbereich umformbar sind.

4. Schaltungsanordnung nach Anspruch 1, **dadurch gekennzeichnet, daß** die Widerstände (R11, R12, R13, R14, R24, R34, R44, R54) in einer Spalte und in einer Zeile der Widerstandsmatrix feste, druckunabhängige Werte aufweisen.

5. Schaltungsanordnung nach Anspruch 4, **dadurch gekennzeichnet, daß** die druckunabhängigen Widerstände (R11, R12, R13, R14, R24, R34, R44, R54) in einer Spalte und einer Zeile am Rand der Widerstandsmatte liegen.

## Claims

1. Circuit arrangement for measuring resistances, arranged in the manner of a matrix, of a pressure-sensitive resistance mat which is arranged in a vehicle seat for detecting the seat occupation,
- the matrix being composed of row lines (LZ1, LZ2, LZ3, LZ4) and column lines (LS1, LS2, LS3, LS4, LS5), each row line being connected to each column line via a resistor (R11, ..., R54),
- each row line (LZ1, LZ2, LZ3, LZ4) and each column line (LS1, LS2, LS3, LS4, LS5) being connected to the output of, in each case, one operational amplifier (OZ1, OZ2, OZ3, OZ4; OS1, OS2, OS3, OS4, OS5) **characterized**
- **in that** a voltage can be applied selectively to the individual resistors (R11, ..., R54) by means of correspondingly actuating the operational amplifiers (OZ1, OZ2, OZ3, OZ4; OS1, OS2, OS3, OS4, OS5) in the rows and columns,
- **in that** each operational amplifier (OZ1, OZ2, OZ3, OZ4; OS1, OS2, OS3, OS4, OS5) which is associated with the row lines (LZ1, LZ2, LZ3, LZ4) or column lines (LS1, LS2, LS3, LS4, LS5) is equipped with a current mirror circuit which detects the output current (IA), flowing through the respectively selected resistor (R11, ..., R54), of the operational amplifier (OZ1, OZ2, OZ3, OZ4) which is connected to this resistor,
- and **in that** a processor (PR) determines the resistance values from the current (IA) flowing through the individual resistors (R11, ..., R54) and the voltages dropping at said resistors (R11, ..., R54).

2. Circuit arrangement according to Claim 1, **characterized in that** the current mirror circuit has a summing element (SU) which adds the current (I1) flowing from an output stage (ES) of the operational amplifier (OP) to its supply voltage source (+U) and the current (I2) flowing to earth from the output stage (ES), so that the output current (IA) of the operational amplifier (OP) which flows through the respectively selected resistor (R11, ..., R54) can be tapped at the output of the summing element (SU).

3. Circuit arrangement according to Claim 2, **characterized in that** switching means (MU1, MU2), with which the two currents (I1, I2) which are fed to the summing element (SU) can be converted into another measured value range, are provided in the current mirror circuit.

4. Circuit arrangement according to Claim 1, **characterized in that** the resistors (R11, R12, R13, R14, R24, R34, R44, R54) have fixed, pressure-independent values in a column and in a row of the resistance matrix.

5. Circuit arrangement according to Claim 4, **characterized in that** the pressure-independent resistors (R11, R12, R13, R14, R24, R34, R44, R54) are located in a column and a row at the edge of the resistance mat.

## Revendications

1. Circuit pour mesurer des résistances, disposées à la façon d'une matrice, d'un mat résistif sensible à la pression placée dans un siège de véhicule pour détecter l'occupation du siège,
- dans lequel la matrice se compose de conduites de ligne (LZ1, LZ2, LZ3, LZ4) et de conduites de colonne (LS1, LS2, LS3, LS4, LS5), chaque conduite de ligne étant reliée à chaque conduite de colonne au moyen d'une résistance (R11, ..., R54),
- dans lequel chaque conduite de ligne (LZ1, LZ2, LZ3, LZ4) et chaque conduite de colonne (LS1, LS2, LS3, LS4, LS5) est raccordée à chaque fois à la sortie d'un amplificateur opérationnel (OZ1, OZ2, OZ3, OZ4 ; OS1, OS2, OS3, OS4, OS5),
**caractérisé en ce que**
- par un amorçage correspondant de l'amplificateur opérationnel (OZ1, OZ2, OZ3, OZ4 ; OS1, OS2, OS3, OS4, OS5) dans les lignes et dans les colonnes, une tension peut être appliquée sélectivement sur les différentes résistances (R11, ..., R54),
- chaque amplificateur opérationnel (OZ1, OZ2, OZ3, OZ4 ; OS1, OS2, OS3, OS4, OS5) faisant partie des conduites de ligne (LZ1, LZ2, LZ3, LZ4) et des conduites de colonne (LS1, LS2, LS3, LS4, LS5) est muni d'un circuit de niveau de courant qui enregistre le courant de sortie (IA), circulant dans la résistance (R11, ..., R54) alors sélectionnée, de l'amplificateur opérationnel (OZ1, OZ2, OZ3, OZ4) lié à cette résistance, et
- un processeur (PR) détermine les valeurs de résistance à partir des courants qui circulent dans les différentes résistances (R11, ..., R54) et des tensions qui y sont établies.

2. Circuit selon la revendication 1,
**caractérisé en ce que**
le circuit de niveau de courant présente un additionneur (SU) qui additionne le courant (I1) circulant entre un étage final (ES) de l'amplificateur opérationnel (OP) et sa source de tension d'alimentation (+U), avec le courant (I2) circulant entre l'étage final (ES) et la masse, de sorte que le courant de sortie (IA) de l'amplificateur opérationnel (OP) circulant dans la résistance (R11, ..., R54) alors sélectionnée peut être saisi à la sortie de l'additionneur (SU).

3. Circuit selon la revendication 2,
**caractérisé en ce que**
dans le circuit de niveau de courant sont prévus des moyens de commutation (MU1, MU2) avec lesquels les deux courants (I1, I2) conduits à l'additionneur (SU) peuvent être convertis en une autre plage de courant.

4. Circuit selon la revendication 1,
**caractérisé en ce que**
les résistances (R11, R12, R13, R14, R24, R34, R44, R54) présentent des valeurs fixes indépendantes de la pression dans une colonne et dans une ligne du mat résistif.

5. Circuit selon la revendication 4,
**caractérisé en ce que**
les résistances (R11, R12, R13, R14, R24, R34, R44, R54) indépendantes de la pression se trouvent dans une colonne et dans une ligne sur le bord du mat résistif.
